# EUROPEAN PATENT APPLICATION

(11) **EP 3 770 981 A1**
(43) Date of publication of application: **27.01.2021**
(21) Application number: 19772145.9
(22) Date of filing: 12.03.2019
(51) Int. Cl.: H01L 41/318, C01G 29/00, C01G 53/00, H01L 41/187

(54) **LIQUID COMPOSITION FOR FORMING PIEZOELECTRIC FILM AND METHOD FOR FORMING PIEZOELECTRIC FILM IN WHICH SAID LIQUID COMPOSITION IS USED**

(30) Priority: 22.03.2018 JP 2018054542; 08.08.2018 JP 2018149083
(71) Applicant: Mitsubishi Materials Corporation, Tokyo 100-8117 (JP)
(72) Inventor: DOI Toshihiro, Naka-shi, Ibaraki 311-0102 (JP); SOYAMA Nobuyuki, Naka-shi, Ibaraki 311-0102 (JP)
(74) Representative: Gille Hrabal
(86) International application number: PCT/JP2019/010065
(87) International publication number: WO 2019/181656

(57) **Abstract**

A liquid composition for forming a piezoelectric film formed of a metal oxide including at least Bi, Na, and Ti. A raw material of the Na is a sodium alkoxide, a raw material of the Ti is a titanium alkoxide, a diol and an amine-based stabilizer are included, and a molar ratio of the amine-based stabilizer with respect to the titanium alkoxide (titanium alkoxide:amine-based stabilizer) is 1:0.5 to 1:4. It is preferable that the metal oxide is included as 4% by mass to 20% by mass with respect to 100% by mass of the liquid composition.

## Description

### TECHNICAL FIELD

The present invention relates to a liquid composition for forming a piezoelectric film which does not include lead, which does not include a highly toxic and corrosive solvent, which has excellent storage stability, and which has a high film density, and a method for forming a piezoelectric film using the liquid composition.

This application claims priority to Japanese Patent Application No. 2018-054542 filed in Japan on March 22, 2018 and Japanese Patent Application No. 2018-149083 filed in Japan on August 8, 2018, the contents of which are incorporated herein by reference.

### BACKGROUND ART

As a piezoelectric material, lead zirconate titanate (PZT) is well known. However, since PZT includes lead, for the purpose of reducing the burden on the environment, there is a demand for a piezoelectric material which does not include lead, that is, a lead-free piezoelectric material. In addition, examples of methods for forming a piezoelectric film include a solid phase method, a vapor phase method, a chemical solution deposition method, and the like. The solid-phase method has a problem in that the firing temperature is high since the piezoelectric film is formed by physically mixing, pulverizing, and molding an oxide powder, and then carrying out firing at 1000°C to 1300°C. In addition, a sputtering method which is a vapor phase method is a method for forming a piezoelectric film by causing, for example, ionized argon or the like to collide with an oxide target in a vacuum and depositing elements repelled thereby onto a substrate; however, there is a problem in that the composition deviates from the oxide used as the target and this method is unsuitable as a method for forming a piezoelectric film using multiple elements. In addition, since a high vacuum is required, the size and cost of the device inevitably increase.

On the other hand, a chemical solution deposition (CSD) method is a method for forming a piezoelectric film by forming a film on a substrate by, for example, a spin coating method, a dip coating method, an ink jet method, or the like, using a precursor solution including a metal element having a target composition and carrying out firing thereon, thus, it is possible to form the piezoelectric film at a lower temperature in comparison with the solid-phase method and, since a high vacuum is not required, the forming is possible with a small and inexpensive device, which is preferable.

In the related art, a method for forming a piezoelectric film having a structural formula of (Bi_{0.5}Na_{0.5})TiO₃-(Bi_{0.5}K_{0.5})TiO₃-Bi(Mg_{0.5}Ti_{0.5})O₃ was proposed as one method for forming a piezoelectric film by the CSD method (for example, refer to Non-Patent Document 1). Non-Patent Document 1 reports that a bulk ceramic of 72.5 mol (Bi_{0.5}Na_{0.5})TiO₃-22.5 mol (Bi_{0.5}K_{0.5})TiO₃-5 mol Bi(Mg_{0.5}Ti_{0.5})O₃(BNT-BKT-BMgT) exhibits a large high electric field piezoelectric constant (d₃₃*=570 pm/V), and, subsequently, a piezoelectric film having the same composition as the above composition is formed on a platinized silicon substrate using a CSD method.

The method shown in Non-Patent Document 1 shows that it was necessary to excessively dope the precursor solution with volatile cations in order to obtain a pure phase perovskite, a thermal annealing temperature of 700°C improved the piezoelectric characteristics (Pₘₐₓ=52 µC/cm² and Pr=12 µC/cm²) quantitative compositional analysis of the films annealed at 650°C and 700°C showed that near theoretical atomic ratios were achieved, the compositional variation observed by electron microscopy through the film thickness matched well with the existence of voids formed between successive spin-coated layers, and the dual-pole and single-pole strain measurements were carried out with a dual-beam laser interferometer, and a high piezoelectric constant (d_{33,r}) of approximately 75 pm/V was obtained.

In this method, bismuth acetate, sodium acetate trihydrate, potassium acetate, magnesium acetate tetrahydrate, and titanium isopropoxide are used as precursors for the liquid composition. First, in order to prevent a reaction with water or a titanium precursor in the atmosphere, titanium isopropoxide is stabilized with acetic acid in a dry atmosphere to form a Ti solution. Next, bismuth acetate is dissolved in propionic acid, and sodium acetate, potassium acetate, and magnesium acetate are separately dissolved in methanol to prepare Bi, Na, K, and Mg solutions. Next, an appropriate amount of a Bi, Na, K, and Mg solution is carefully dropped into the Ti solution through a syringe. When preparing the liquid composition, an excess amount of cations is added to compensate for the high volatility of the cations.

### CITATION LIST

### [Non Patent Literature]

[Non Patent Document 1] Y. H. Jeon et al., "Large Piezoresponse and Ferroelectric Properties of (Bi0.5Na0.5)TiO3-(Bi0.5K0.5)TiO3-Bi(Mg0.5Ti0.5)O3 Thin Films Prepared by Chemical Solution Deposition", J. Am. Ceram. Soc., 1-7 (2013)

### SUMMARY OF INVENTION

### TECHNICAL PROBLEM

However, there is a problem that the piezoelectric film formed of the liquid composition disclosed in Non-Patent Document 1 has a low film density and is not a dense film. In addition, since a propionic acid having corrosiveness is used as a solvent, there is a problem that it is necessary to take measures against corrosion of the manufacturing apparatus during mass production. In addition, there is a problem that methanol, which is highly harmful to the human body, is used as a solvent.

An object of the present invention is to provide a liquid composition for forming a piezoelectric film which does not include lead, which does not include a highly toxic and corrosive solvent, which has excellent storage stability, and which has a high film density, and a method for forming a piezoelectric film using the liquid composition.

### [Solution to Problem]

A first aspect of the present invention is a liquid composition for forming a piezoelectric film including a metal oxide including at least Bi, Na, and Ti, in which a raw material of the Na is a sodium alkoxide, a raw material of the Ti is a titanium alkoxide, a diol and an amine-based stabilizer are included, and a molar ratio of the amine-based stabilizer to the titanium alkoxide (titanium alkoxide:amine-based stabilizer) is 1:0.5 to 1:4.

A second aspect of the present invention is the liquid composition according to the first aspect, further including any one selected from the group consisting of Ba, K, Mg, Zn, and Ni.

A third aspect of the present invention is the liquid composition according to the first or second aspect, further including Sr and Zr.

A fourth aspect of the present invention is the liquid composition according to any one of the first to third aspects, in which the metal oxide is included as 4% by mass to 20% by mass with respect to 100% by mass of the liquid composition.

A fifth aspect of the present invention is a method for forming a crystallized piezoelectric film by coating a substrate with the liquid composition according to any one of the first to fourth aspects and carrying out pre-firing, and then carrying out firing.

A sixth aspect of the present invention is a piezoelectric film formed of a metal oxide including at least Bi, Na, and Ti, in which a film density of the piezoelectric film is 84% to 99% when measured by a scanning electron microscope (referred to below as SEM).

A seventh aspect of the present invention is the piezoelectric film according to the sixth aspect, further including any one selected from the group consisting of Ba, K, Mg, Zn, and Ni.

An eighth aspect of the present invention is the piezoelectric film according to the sixth or seventh aspects, further including Sr and Zr.

A ninth aspect of the present invention is the piezoelectric film according to the sixth aspect, in which the metal oxide is (Bi,Na)TiO₃ and has a perovskite structure.

A tenth aspect of the present invention is the piezoelectric film according to the seventh or eighth aspects, in which the metal oxide is any one selected from the group consisting of (Bi,Na)TiO₃-BaTiO₃, (Bi,Na)TiO₃-(Bi,K)TiO₃, (Bi,Na)TiO₃-Bi(Mg,Ti)O₃, (Bi,Na)TiO₃-(Bi,K)TiO₃-Bi(Zn,Ti)O₃,(Bi,Na)TiO₃-(Bi,K)TiO₃-Bi(Ni,Ti)O₃, (Bi,Na)TiO₃-SrZrO₃, and (Bi,Na)TiO₃-(Bi,K)TiO₃-SrZrO₃, and has a perovskite structure.

### ADVANTAGEOUS EFFECTS OF INVENTION

In the liquid composition of the first aspect of the present invention, by using sodium alkoxide as the raw material of Na without using Na acetate as in Non-Patent Document 1, compared to the acetate, sodium alkoxide lowers the thermal decomposition temperature of the liquid composition during thermal annealing after coating the liquid composition on a substrate, thus, the carbon residue in the film is reduced and it is possible to form a denser piezoelectric film with a high film density. In addition, this liquid composition does not include lead, does not include a highly toxic and corrosive solvent, but does include a predetermined amount of a diol and an amine-based stabilizer, thus, the film density is not lowered and the storage stability is excellent.

Since the liquid composition according to the second aspect of the present invention further includes any one selected from the group consisting of Ba, K, Mg, Zn, and Ni, it is possible to form a piezoelectric film having higher piezoelectric characteristics.

Since the liquid composition according to the third aspect of the present invention further includes Sr and Zr, it is possible to obtain high piezoelectric characteristics.

In the liquid composition according to the fourth aspect of the present invention, since the metal oxide is included as 4% by mass to 20% by mass with respect to 100% by mass of the liquid composition, it is possible to obtain a desired piezoelectric film thickness and the storage stability is even more excellent.

In the method for forming a piezoelectric film according to the fifth aspect of the present invention, since the piezoelectric film is formed from the liquid composition described above, it is possible to form a denser film which is lead-free and has a high film density.

The piezoelectric film of the sixth aspect of the present invention is lead-free and the density of the piezoelectric film when measured by SEM is high at 84% to 99%.

The piezoelectric film according to the seventh aspect of the present invention further includes any one selected from the group consisting of Ba, K, Mg, Zn, and Ni and thus has higher piezoelectric characteristics.

The piezoelectric film according to the eighth aspect of the present invention further includes Sr and Zr and thus has a high film density.

In the piezoelectric film of the ninth and tenth aspects of the present invention, since the metal oxide is any one selected from the group consisting of (Bi,Na)TiO₃, (Bi,Na)TiO₃-BaTiO₃, (Bi,Na)TiO₃-(Bi,K)TiO₃, (Bi,Na)TiO₃-Bi(Mg,Ti)O₃, (Bi,Na)TiO₃-(Bi,K)TiO₃-Bi(Zn,Ti)O₃, or (Bi,Na)TiO₃-(Bi,K)TiO₃-Bi(Ni,Ti)O₃, (Bi,Na)TiO₃-SrZrO₃, and (Bi,Na)TiO₃-(Bi,K)TiO₃-SrZrO₃ and is lead-free, thus, in comparison with a piezoelectric film of a lead-based material, the burden on the environment is small.

### BRIEF DESCRIPTION OF DRAWINGS

Fig. 1 is a photograph in which a cross-section of a piezoelectric film on a Pt lower electrode of an Example is imaged by SEM.
Fig. 2 is a photograph in which a cross-section of a piezoelectric film on a Pt lower electrode of a Comparative Example is imaged by SEM.

### DESCRIPTION OF EMBODIMENTS

Next, a description will be given of an embodiment for carrying out the present invention with reference to the drawings.

### [Liquid Composition for Forming Piezoelectric Film]

The liquid composition for forming a piezoelectric film of the present embodiment includes at least Bi, Na, and Ti, and, in addition to these metal raw materials, may include Ba, K, Mg, Zn, Ni, and the like, Sr and Zr may be included together with any one of Ba, K, Mg, Zn, Ni, or the like, or Sr and Zr may be included without including Ba, K, Mg, Zn, Ni, or the like. The feature of the present embodiment is that the raw material of Na is sodium alkoxide, the raw material of Ti is titanium alkoxide, and the liquid composition includes a diol as a solvent of the alkoxide and an amine-based stabilizer for stabilizing a reaction when manufacturing the liquid composition. Using sodium alkoxide as a raw material of Na instead of acetate such as the sodium acetate trihydrate of Non-Patent Document 1 lowers the thermal decomposition temperature of the liquid composition during thermal annealing after coating the liquid composition on a substrate, thus, the amount of carbon residue in the film is reduced and it is possible to form a denser piezoelectric film with a high film density. When an amine-based stabilizer is included as a stabilizer, unlike other stabilizers such as acetic acid and acetylacetone, since the stabilizing effect of the precursor material is high because the coordinating ability is high, the liquid is stable and a film is uniformly formed even when the liquid composition is coated and the storage stability of the liquid composition is improved.

Examples of raw materials of Bi include bismuth acetate, bismuth 2-ethylhexanoate, bismuth(III) nitrate pentahydrate, and the like. Examples of sodium alkoxides include sodium methoxide: Na₂(OMe), sodium ethoxide: Na₂(OEt), sodium t-butoxide: Na2(OtBu), and the like.

Examples of titanium alkoxides include titanium tetraethoxide: Ti(OEt)₄, titanium tetraisopropoxide: Ti(OiPr)₄, titanium tetra n-butoxide: Ti(OiBu)₄, titanium tetraisobutoxide: Ti(OiBu)₄, titanium tetra-t-butoxide: Ti(OtBu)₄, titanium dimethoxydiisopropoxide: Ti(OMe)₂(OiPr)₂, and the like.

In a case where Ba is used, it is possible to use barium acetate, barium 2-ethylhexanoate, or the like as a raw material of Ba. In a case where K is used, it is possible to use potassium acetate, potassium ethoxide, or the like as a raw material of K. In a case where Mg is used, it is possible to use magnesium acetate, magnesium nitrate hexahydrate, or the like as a raw material of Mg. In a case where Zn is used, it is possible to use zinc acetate, zinc nitrate hexahydrate, or the like as a raw material of Zn. In a case where Ni is used, it is possible to use nickel nitrate hexahydrate, nickel acetate, or the like as a raw material of Ni. In a case where Sr and Zr are used, it is possible to use strontium acetate, strontium 2-ethylhexanoate, or the like as the raw material of Sr, and it is possible to use zirconium butoxide, zirconium tert-butoxide, or the like as Zr.

As the diol, it is possible to use one type or two or more types selected from propylene glycol, ethylene glycol, 1,3-propanediol, and the like. Among these, propylene glycol is particularly preferable from the viewpoint of the viscosity and storage stability of the liquid.

Examples of amine-based stabilizers include 2-methylaminoethanol, 2-dimethylaminoethanol, 1-amino-2-propanol, ethanolamine, dimethanolamine, diethanolamine, triethanolamine, and the like.

### [Method for Manufacturing Liquid Composition]

The liquid composition of the present embodiment is manufactured by the following method.

### (1) A case of further including any one of Ba, K, Mg, Zn, and Ni in addition to Bi, Na, and Ti

First, an organic solvent such as ethanol, 1-butanol, or isopropanol, sodium alkoxide, and an alkoxide or non-alkoxide such as Ba are placed in a container and stirred at room temperature for 30 to 60 minutes to obtain a reddish-brown suspension. Then, titanium alkoxide is added to this suspension and refluxed for 30 minutes to prepare a first solution. A raw material of Bi and diols such as propylene glycol, ethylene glycol, and 1,3-propanediol are added to the first solution and refluxed for 30 to 60 minutes to prepare a second solution. Stabilizers such as acetic acid and acetylacetone are added to the second solution and refluxed for 30 to 60 minutes to prepare a third solution. Then, the solvent is desorbed from the third solution by distillation under reduced pressure to remove the organic solvent and reaction by-products. Diols such as propylene glycol, ethylene glycol, and 1,3-propanediol are added to the obtained solution and the liquid is diluted to 15% by mass to 25% by mass in terms of oxide. Further, an amine-based stabilizer of the present embodiment is added to the diluted liquid as a stabilizer, and then the liquid is diluted with an organic solvent such as ethanol, 1-butanol, or isopropanol to 4% by mass to 20% by mass in terms of oxide, and preferably 5% by mass to 10% by mass. Contaminants are removed by filtering the obtained liquid with a filter to obtain a liquid composition. When the amount is less than 4% by mass in terms of oxide, it is possible to obtain a good film, but the film thickness is excessively thin, thus, the productivity until the desired thickness is obtained becomes poor. When the amount exceeds 20% by mass, it is necessary to reduce the amount of diol such as propylene glycol in order to carry out concentration and the liquid composition is easily precipitated.

### (2) A case where Sr and Zr are further included in addition to Bi, Na and Ti, together with any one of Ba, K, Mg, Zn, and Ni

First, an organic solvent such as ethanol, 1-butanol, or isopropanol, sodium alkoxide, and an alkoxide or non-alkoxide of any one of Ba, K, Mg, Zn, or Ni are placed in a container and stirred at room temperature for 30 to 60 minutes to obtain a reddish-brown suspension. Next, titanium alkoxide and Zr alkoxide are added to this suspension and refluxed for 30 minutes to prepare a first solution. A raw material of Bi, a non-alkoxide of Sr, and a diol such as propylene glycol, ethylene glycol, and 1,3-propanediol are added to the first solution and refluxed for 30 to 60 minutes to prepare a second solution. Stabilizers such as acetic acid and acetylacetone are added to the second solution and refluxed for 30 to 60 minutes to prepare a third solution. From then, the liquid composition is obtained in the same manner as the case of (1) described above where any one of Ba, K, Mg, Zn, and Ni is further included.

In this manufacturing method, the mixing of the organic solvent and sodium alkoxide to the final dilution of the liquid is performed in one pot. Performed in one pot (container) means that after preparing the first solution in one container, the raw material of Bi is mixed with the first solution in the same container and reacted to prepare the second solution, then, a stabilizer is mixed with the second solution in the same container to prepare a third solution, and then, the organic solvent is mixed with the third mixed liquid in the same container to manufacture the liquid composition of the present embodiment.

It is desirable that the mixture of the raw material of Bi, the raw material of Na, the raw material of K, the raw material of Mg, the raw material of Zn, the raw material of Ni, and the raw material of Ti has a ratio of A site ions:B site ions of 125:100 to 105:100. This is because the main A-site ions Bi, Na, and K evaporate during firing and the film composition after firing deviates from the charged composition.

The addition amount of the amine-based stabilizer characteristic of the present embodiment is at a molar ratio (Ti:amine-based stabilizer) with respect to the raw material of Ti of 1:0.5 to 1:4, and preferably 1:1 to 1:2. When the molar ratio of the amine-based stabilizer is less than 1:0.5, the storage stability of the liquid composition is poor and precipitation or gelation occurs. When this molar ratio exceeds 1:4, the thermal decomposition temperature of the liquid composition increases during the thermal annealing after the liquid composition is coated on the substrate, the amount of carbon residue in the film increases, and it is not possible to form a dense piezoelectric film.

In addition, in the present embodiment, the diol is preferably included as 5% by mass to 35% by mass, when the liquid composition is 100% by mass. When less than 5% by mass, the stabilizing effect is weak and precipitation easily occurs and when more than 35% by mass, the film thickness is excessively thick and voids are easily generated.

### [Method for Forming Piezoelectric Film]

The piezoelectric film of the present embodiment is formed by a sol-gel method using the composition described above as a raw material solution. First, the composition described above is coated onto a substrate by spin coating, dip coating, a Liquid Source Misted Chemical Deposition (LSMCD) method, an electrostatic spraying method, or the like to form a coating film (gel film) having a desired thickness. As the substrate on which the piezoelectric film is formed, a heat resistant substrate such as a silicon substrate or a sapphire substrate on which a lower electrode is formed is used.

After forming a coating film on the substrate, this coating film is pre-fired and then fired to cause crystallization. The pre-firing is performed under predetermined conditions using a hot plate, rapid thermal annealing (RTA), or the like. The pre-firing is performed to remove the solvent and to thermally decompose or hydrolyze the metal compound so as to be converted into a complex oxide having a perovskite structure, thus, it is desirably performed in air (the atmosphere), in an oxide atmosphere, or in a moisture-containing atmosphere. Even with heating in air, the moisture required for hydrolysis is sufficiently secured by the humidity in the air. Before the pre-firing, in particular, low temperature heating (drying) may be performed at a temperature of 70°C to 90°C for 0.5 to 5 minutes using a hot plate or the like to remove a low boiling point solvent and adsorbed water molecules.

The pre-firing is performed at a temperature of 280°C to 320°C and is preferably performed by holding at the above temperature for 1 to 5 minutes. If the temperature during the pre-firing is lower than the lower limit value, it is not possible to sufficiently remove the solvent or the like and there is a concern that the effect of suppressing voids and cracks may be reduced. On the other hand, when the temperature exceeds the upper limit value, there is a concern that the productivity may decrease. In addition, when the holding time during the pre-firing is excessively short, similarly, it may not be possible to sufficiently remove the solvent or the like or the pre-firing temperature may have to be set to a higher temperature than necessary in order to sufficiently remove the solvent. On the other hand, when the holding time during pre-firing is excessively long, the productivity may decrease.

Firing is a step for firing and crystallizing the coating film after pre-firing at a temperature of the crystallization temperature or higher and, due to this, a piezoelectric film is obtained. Examples of the firing atmosphere in this crystallization step include O₂, N₂, Ar, H₂, and the like, or mixed gas atmospheres thereof, and the like, but a mixed gas atmosphere of O₂ and N₂ (O₂:N₂=1:0.3 to 0.7) is particularly suitable. The reason why this mixed gas atmosphere is particularly preferable is that the production of a heterophase such as a pyrochlore phase is suppressed, and as a result, a film having high piezoelectric characteristics is easily obtained.

The firing is preferably performed at 600°C to 700°C for approximately 1 to 5 minutes. The firing may be performed by rapid thermal annealing (RTA). In a case where the firing is carried out by rapid thermal annealing (RTA), the temperature increase rate is preferably 10°C/sec to 100°C/sec. Here, the steps described above from coating of the composition to pre-firing and firing may be repeated a plurality of times to form a thicker piezoelectric film.

### [Characteristics of Piezoelectric Film]

The piezoelectric film of the present embodiment is a piezoelectric film including at least Bi, Na, and Ti and formed of a metal oxide having a perovskite structure. In addition, the piezoelectric film of the present embodiment may further include any one of Ba, K, Mg, Zn, and Ni in addition to Bi, Na, or Ti. This piezoelectric film is characterized in that the film density of the piezoelectric film when measured with a scanning electron microscope (SEM) is 84% to 99% in order to obtain desired piezoelectric characteristics. The preferable film density is 88% to 99%.

The composition of the metal oxides described above is (Bi,Na)TiO₃, (Bi,Na)TiO₃-BaTiO₃, (Bi,Na)TiO₃-(Bi,K)TiO₃, (Bi,Na)TiO₃-Bi(Mg,Ti)O₃, (Bi,Na)TiO₃-(Bi,K)TiO₃-Bi(Zn,Ti)O₃, (Bi,Na)TiO₃-(Bi,K)TiO₃-Bi(Ni,Ti)O₃, (Bi,Na)TiO₃-SrZrO₃, (Bi,Na)TiO₃-(Bi,K)TiO₃-SrZrO₃, and the like. (Bi,Na)TiO₃ is exemplary example of the composition of (Bi_{0.5}Na_{0.5})TiO₃.

### EXAMPLES

Next, a detailed description will be given of Examples of the present invention together with Comparative Examples.

### [7 Types of Stabilizers]

The seven types of stabilizers used in the liquid compositions of Examples 1 to 15 and Comparative Examples 1 to 5 of the present invention are shown in Table 1 and Table 2 below. Table 1 shows 5 kinds of amine-based stabilizers (No. 1 to No. 5), and Table 2 shows 2 kinds of other stabilizers (No. 6 to No. 7). Furthermore, Table 3 shows three kinds of diols (No.8 to No.10).

**Table 1**

| | Content of amine-based stabilizer |
|---|---|
| No.1 | 2-dimethylaminoethanol |
| No.2 | 1-amino-2-propanol |
| No.3 | ethanolamine |
| No.4 | diethanolamine |
| No.5 | triethanolamine |

**Table 2**

| | Content of other stabilizer |
|---|---|
| No.6 | Acetylacetone |
| No.7 | Acetic acid |

**Table 3**

| | Diol |
|---|---|
| No.8 | Propylene glycol |
| No.9 | Ethylene glycol |
| No.10 | 1,3-propanediol |

### <Example 1>

Ethanol and sodium ethoxide were placed in a flask and stirred at room temperature for 30 minutes to obtain a reddish-brown suspension. Tetratitanium isopropoxide was added to this suspension and refluxed for 30 minutes to prepare a first solution. Bismuth 2-ethylhexanoate and propylene glycol (No. 8 in Table 3) were added to this first solution and refluxed for 30 minutes to prepare a second solution. Acetylacetone (No. 6 in Table 2) was added to the second solution as a stabilizer and refluxed for 30 minutes to prepare a third solution. Subsequently, the solvent was desorbed from the third solution to remove ethanol and reaction by-products. Propylene glycol (No. 8 in Table 3) was added to the obtained solution and diluted to 15% by mass in terms of oxide. Furthermore, 2-dimethylaminoethanol (No. 1 in Table 1) was added to the diluted liquid as a stabilizer such that the molar ratio of Ti:stabilizer was 1:1, and then the liquid was diluted with 1-butanol to 8% by mass in terms of oxide. Contaminants were removed by filtering the obtained liquid with a filter to obtain a liquid composition.

Here, the addition amount of ethanol was 1:12 in terms of molar ratio (Ti:ethanol) to the raw material of Ti. The addition amount of sodium ethoxide was 1:0.58 in terms of molar ratio (Ti:sodium ethoxide) to the raw material of Ti. The addition amount of bismuth 2-ethylhexanoate was 1:0.54 in terms of molar ratio (Ti:bismuth 2-ethylhexanoate) to the raw material of Ti. The addition amount of propylene glycol was 1:7 in terms of molar ratio (Ti:propylene glycol) to the raw material of Ti. Table 4 shows the types of Bi raw material, Na raw material, Ti raw material, other metal raw materials, stabilizers, and diols which are solvents, in the liquid composition, and Table 5 shows each mixed mol% of the Bi raw material, Na raw material, Ti raw material, and the other metal raw materials in the liquid composition, the mass ratio of the metal oxide, the molar ratio of the amine-based stabilizer to the Ti raw material, and the mass ratio of the diol. In Table 4, the types of raw materials are not described with specific compound names and those types which are not alkoxides are described as "non-alkoxide".

**Table 4**

| | Types of liquid composition raw material | | | | | | | | | | | | |
|---|---|---|---|---|---|---|---|---|---|---|---|---|---|
| | Bi | Na | Ti | Ba | K | Mg | Zn | Ni | Sr | Zr | Stabilizer | | Solvent |
| | | | | | | | | | | | Amine | Others | Diol |
| Example1 | Non-alkoxide | Alkoxide | Alkoxide | - | - | - | - | - | - | - | No.1 | No.6 | No.8 |
| Example2 | Non-alkoxide | Alkoxide | Alkoxide | - | - | - | - | - | - | - | No.2 | No.6 | No.8 |
| Example3 | Non-alkoxide | Alkoxide | Alkoxide | - | - | - | - | - | - | - | No.3 | No.6 | No.8 |
| Example4 | Non-alkoxide | Alkoxide | Alkoxide | - | - | - | - | - | - | - | No.4 | No.6 | No.8 |
| Example5 | Non-alkoxide | Alkoxide | Alkoxide | - | - | - | - | - | - | - | No.5 | No.6 | No.8 |
| Example6 | Non-alkoxide | Alkoxide | Alkoxide | Non-alkoxide | - | - | - | - | - | - | No.1 | No.6 | No.8 |
| Example7 | Non-alkoxide | Alkoxide | Alkoxide | - | - | - | - | - | - | - | No.1 | No.6 | N0.8 |
| Example8 | Non-alkoxide | Alkoxide | Alkoxide | - | - | - | - | - | - | - | No.1 | No.6 | No.8 |
| Example9 | Non-alkoxide | Alkoxide | Alkoxide | - | - | - | - | - | - | - | No.1 | No.6 | No.8 |
| Example10 | Non-alkoxide | Alkoxide | Alkoxide | - | - | - | - | - | - | - | No.1 | No.6 | No.8 |
| Example11 | Non-alkoxide | Alkoxide | Alkoxide | - | - | - | - | - | - | - | No.1 | No.6 | No.8 |
| Example12 | Non-alkoxide | Alkoxide | Alkoxide | - | Non-alkoxide | - | - | - | - | - | No.1 | No.6 | No.9 |
| Example13 3 | Non-alkoxide | Alkoxide | Alkoxide | - | - | Non-alkoxide | - | - | - | - | No.1 | No.6 | No.10 |
| Example14 | Non-alkoxide | Alkoxide | Alkoxide | - | - | - | Non-alkoxide | - | - | - | No.1 | No.6 | No.8 |
| Example15 | Non-alkoxide | Alkoxide | Alkoxide | - | - | - | - | Non-alkoxide | - | - | No.1 | No.6 | No.8 |
| Example16 | Non-alkoxide | Alkoxide | Alkoxide | - | Alkoxide | - | - | - | Non-alkoxide | Alkoxide | No.1 | No.6 | No.8 |
| Example17 | Non-alkoxide | Alkoxide | Alkoxide | - | Alkoxide | - | - | - | Non-alkoxidc | Alkoxide | No.1 | No.6 | No.8 |
| Example18 | Non-alkoxide | Alkoxide | Alkoxide | - | Alkoxide | - | - | - | Non-alkoxide | Alkoxide | No.1 | No.6 | No.8 |
| Example19 | Non-alkoxide | Alkoxide | Alkoxide | - | - | - | - | - | Non-alkoxide | Alkoxide | No.1 | No.6 | No.8 |
| Comparative Examplel | Non-alkoxide | Alkoxide | Alkoxide | - | | | | | | | - | No.7 | No.8 |
| Comparative Example2 | Non-alkoxide | Non-alkoxide | Alkoxide | - | - | - | - | - | - | - | No.1 | No.6 | No.8 |
| Comparative Example3 | Non-alkoxide | Alkoxide | Alkoxide | - | - | - | - | - | - | - | - | - | No.8 |
| Comparative Example4 | Non-alkoxide | Alkoxide | Alkoxide | - | - | - | - | - | - | - | No.1 | No.6 | No.8 |
| Comparative Example5 | Non-alkoxide | Alkoxide | Alkoxide | - | - | - | - | - | - | - | No.1 | No.6 | No.8 |

**Table 5**

| | Ratio of liquid composition raw material | | | | | | | | | | | | |
|---|---|---|---|---|---|---|---|---|---|---|---|---|---|
| | Bi Mol% | Na Mol% | Ti Mol% | Ba Mol% | K Mol% | Mg Mol% | Zn Mol% | Ni Mol% | Sr Mol% | Zr Mol% | Metal oxide mass% | Ti:Amine molar ratio | Diol mass% |
| Example1 | 54 | 58 | 100 | - | - | - | - | - | - | - | 8.0 | 1:1 | 15.0 |
| Example2 | 54 | 58 | 100 | - | - | - | - | - | - | - | 8.0 | 1:1 | 15.0 |
| Example3 | 54 | 58 | 100 | - | - | - | - | - | - | - | 8.0 | 1:1 | 15.0 |
| Example4 | 54 | 58 | 100 | - | - | - | - | - | - | - | 4.0 | 1:1 | 15.0 |
| Example5 | 54 | 58 | 100 | - | - | - | - | - | - | - | 20.0 | 1:1 | 15.0 |
| Example6 | 46 | 49 | 100 | 15 | - | - | - | - | - | - | 8.0 | 1:1 | 15.0 |
| Example7 | 54 | 58 | 100 | - | - | - | - | - | - | - | 8.0 | 1:0.5 | 15.0 |
| Example8 | 54 | 58 | 100 | - | - | - | - | - | - | - | 8.0 | 1:2 | 15.0 |
| Example9 | 54 | 58 | 100 | - | - | - | - | - | - | - | 8.0 | 1:4 | 15.0 |
| Example 10 | 54 | 58 | 100 | - | - | - | - | - | - | - | 3.8 | 1:1 | 15.0 |
| Example 11 | 54 | 58 | 100 | - | - | - | - | - | - | - | 21.0 | 1:1 | 15.0 |
| Example12 | 54 | 36 | 100 | - | 24 | - | - | - | - | - | 8.0 | 1:1 | 5.0 |
| Example13 | 54 | 58 | 100 | - | - | 3 | - | - | - | - | 8.0 | 1:1 | 15.0 |
| Example14 | 54 | 58 | 100 | - | - | - | 3 | - | - | - | 8.0 | 1:1 | 35.0 |
| Example15 | 54 | 58 | 100 | - | - | - | - | 3 | - | - | 8.0 | 1:1 | 15.0 |
| Example16 | 54 | 44 | 97.5 | - | 11 | - | - | - | 2.5 | 2.5 | 8.0 | 1:1 | 15.0 |
| Example 17 | 54 | 33 | 97.5 | - | 22 | - | - | - | 2.5 | 2.5 | 8.0 | 1:1 | 15.0 |
| Example18 | 54 | 22 | 97.5 | - | 33 | - | - | - | 2.5 | 2.5 | 8.0 | 1:1 | 15.0 |
| Example19 | 54 | 56 | 97.5 | - | - | - | - | - | 2.5 | 2.5 | 8.0 | 1:1 | 15.0 |
| Comparative Example 1 | 54 | 58 | 100 | - | - | - | - | - | - | - | 8.0 | - | 15.0 |
| Comparative Example2 | 54 | 58 | 100 | - | - | - | - | - | - | - | 8.0 | 1:1 | 15.0 |
| Comparative Example3 | 54 | 58 | 100 | - | - | - | - | - | - | - | 8.0 | - | 15.0 |
| Comparative Example4 | 54 | 58 | 100 | - | - | - | - | - | - | - | 8.0 | 1:0.1 | 15.0 |
| Comparative Example5 | 54 | 58 | 100 | - | - | - | - | - | - | - | 8.0 | 1:7 | 15.0 |

### <Examples 2 to 15>

As shown in Table 4 and Table 5, the raw material and stabilizers were selected and the mixed mol% of each raw material, the metal oxide concentration, and the molar ratio of the amine-based stabilizers with respect to the Ti raw material were determined to obtain the liquid compositions of Examples 2 to 15 in the same manner as Example 1. In Examples 1 to 15, any one of the amine-based stabilizers of No. 1 to No. 5 shown in Table 1 or the acetylacetone of No. 6 shown in Table 2 as the stabilizer was used together with the diol of any one of No. 8 to No. 1 0 shown in Table 3 as the solvent. In addition, as a metal raw material other than the raw material of Bi, the raw material of Na, and the raw material of Ti, in Example 6, barium 2-ethylhexanoate as the raw material of Ba was added together with bismuth 2-ethylhexanoate such that the molar ratio was 0.15 with respect to the Ti raw material. In addition, in Example 12, potassium acetate as a raw material of K was added together with bismuth 2-ethylhexanoate such that the molar ratio was 0.24 with respect to the raw material of Ti. In addition, in Example 13, magnesium acetate as a raw material of Mg was added together with bismuth 2-ethylhexanoate such that the molar ratio was 0.3 with respect to the raw material of Ti. In addition, in Example 14, zinc acetate was added as a raw material of Zn together with bismuth 2-ethylhexanoate such that the molar ratio was 0.3 with respect to the raw material of Ti. Furthermore, in Example 15, nickel acetate was added as a raw material of Ni together with bismuth 2-ethylhexanoate such that the molar ratio was 0.3 with respect to the raw material of Ti.

### <Example 16>

Ethanol, sodium ethoxide, and potassium ethoxide were placed in a flask and stirred at room temperature for 30 minutes to obtain a reddish-brown suspension. Tetratitanium isopropoxide and zirconium butoxide were added to this suspension and refluxed for 30 minutes to prepare a first solution. Bismuth 2-ethylhexanoate, strontium acetate 0.5 hydrate and propylene glycol were added to this first solution and refluxed for 30 minutes to prepare a second solution. Acetylacetone was added to the second solution as a stabilizer and refluxed for 30 minutes to prepare a third solution. Subsequently, the solvent was desorbed from the third solution to remove ethanol and reaction by-products. Propylene glycol was added to the obtained solution and diluted to 15% by mass in terms of oxide. Furthermore, 2-dimethylaminoethanol (No. 1 in Table 1) was added to the diluted solution as a stabilizer such that the molar ratio of Ti:stabilizer was 1:1, and then the liquid was diluted with 1-butanol to 8% by mass in terms of oxide. Contaminants were removed by filtering the obtained liquid with a filter to obtain a liquid composition. The addition amount of ethanol, the addition amount of sodium ethoxide, the addition amount of bismuth 2-ethylhexanoate, and the addition amount of propylene glycol were the same as in the liquid composition of Example 1. Table 4 shows the types of the raw material of Bi, the raw material of Na, the raw material of Ti, other metal raw materials, stabilizers, and diols which are solvents, in the liquid composition, and Table 5 shows each mixed mol% of the raw material of Bi, the raw material of Na, the raw material of Ti, and the other metal raw materials, the mass ratio of the metal oxide, the molar ratio of the amine-based stabilizer with respect to the raw material of Ti, and the mass ratio of the diol, in the liquid composition.

### <Examples 17 to 19>

As shown in Table 4 and Table 5, liquid compositions of Examples 17 to 19 were obtained in the same manner as the liquid composition of Example 16 except for the addition amounts of the raw material of Na and the raw material of K. In addition, in Example 19, the raw material of K is not added.

### <Comparative Example 1>

Only acetic acid (No. 7 in Table 2) was used as a stabilizer and the liquid was diluted to 8% by mass in terms of oxide with acetic acid and 1-butanol at a 1:9 molar ratio of acetic acid: 1-butanol. A liquid composition was obtained in the same manner as in Example 1 except for the above.

### <Comparative Example 2>

A liquid composition was obtained in the same manner as in Example 1 except that sodium acetate trihydrate was used as a raw material of Na instead of sodium alkoxide.

### <Comparative Example 3>

As the stabilizer, neither an amine-based stabilizer nor any other stabilizer was used. A liquid composition was obtained in the same manner as in Example 1 except for the above.

### <Comparative Example 4>

A liquid composition was obtained in the same manner as in Example 1 except that the molar ratio of the amine-based stabilizer with respect to the raw material of Ti was 1:0.1.

### <Comparative Example 5>

A liquid composition was obtained in the same manner as in Example 1 except that the molar ratio of the amine-based stabilizer with respect to the raw material of Ti was 1:7.

### <Comparison Evaluation Test>

In order to confirm the storage stability of the liquid compositions obtained in Examples 1 to 19 and Comparative Examples 1 to 5, after storing the obtained liquid compositions in a refrigerator at 5°C for 1 month in a state of being sealed in a container, the presence or absence of precipitation of the liquid composition and the presence or absence of gelation were visually examined.

In addition, in order to investigate the film composition and film density, a piezoelectric film was formed by the following method. First, a 4-inch Si substrate was thermally oxidized to form a 500 nm oxide film on the surface thereof. A titanium oxide film was formed by forming Ti with a thickness of 20 nm on the oxide film by a sputtering method and subsequently carrying out firing at 700°C for 1 minute in an oxygen atmosphere in an infrared rapid heating (RTA) furnace. A (111)-oriented Pt lower electrode having a thickness of 100 nm was formed on the titanium oxide film by a sputtering method.

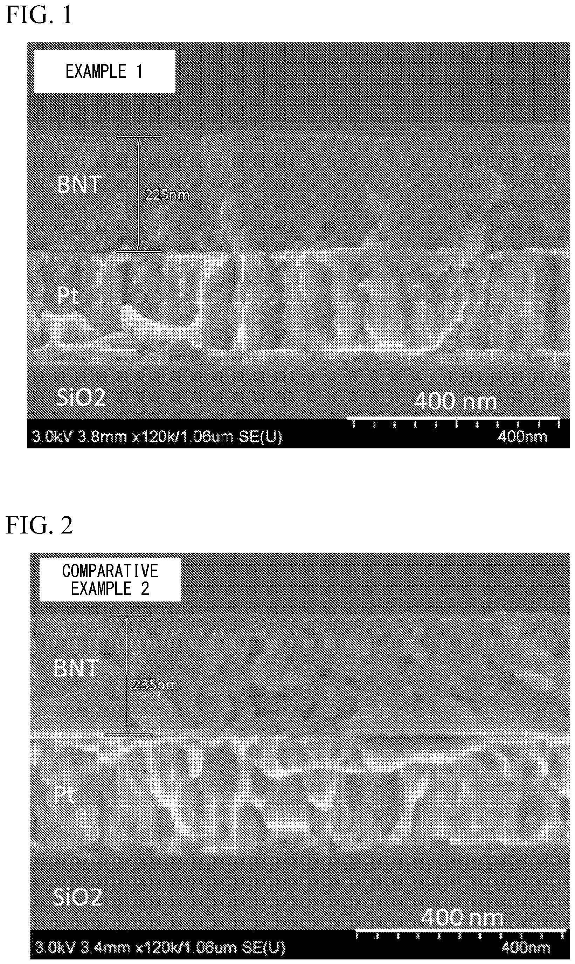

500 µL of the liquid compositions obtained in Examples 1 to 19 and Comparative Examples 1 to 5 was separately dropped on the Pt lower electrode of the substrate described above and spin coating was performed at 4000 rpm for 15 seconds. Furthermore, pre-firing was performed for 5 minutes on a hot plate at 300°C. After repeating this operation three times, firing was performed in an infrared rapid heating furnace at 700°C, an oxygen atmosphere, a temperature increase rate of 10°C per second, and a holding time of 1 minute. The film density (%) of the obtained film was measured by a SEM. The cross-section of the film was observed by a SEM and the cross-sectional image was image-analyzed to calculate the area of the film and the area of the void portions in the film, and the film density (%) was calculated by performing the calculation of [(area of film-area of void portions)/area of film]×100. The results are shown in Table 6. Furthermore, a cross-sectional photograph of the piezoelectric film of Example 1 is shown in Fig. 1 and a cross-sectional photograph of the piezoelectric film of Comparative Example 2 is shown in Fig. 2. When the composition of the film of Example 1 was analyzed by fluorescent X-ray analysis using a fluorescent X-ray analyzer (model name: Primus III+ manufactured by Rigaku Corporation), the composition was (Bi0.5Na0.5)TiO₃.

**Table 6**

| | Evaluation of liquid composition | | Evaluation of piezoelectric film |
|---|---|---|---|
| | Precipitation of liquid | Gelation of liquid | Film density (%) |
| Examplel | No | No | 96 |
| Example2 | No | No | 95 |
| Example3 | No | No | 97 |
| Example4 | No | No | 99 |
| Example5 | No | No | 90 |
| Example6 | No | No | 94 |
| Example 7 | No | No | 96 |
| Example 8 | No | No | 88 |
| Example9 | No | No | 84 |
| Example 10 | No | No | 91 |
| Example 11 | Slight | No | 89 |
| Example 12 | No | No | 90 |
| Example 13 | No | No | 92 |
| Example 14 | No | No | 92 |
| Example 15 | No | No | 90 |
| Example 16 | No | No | 98 |
| Example 17 | No | No | 99 |
| Example 18 | No | No | 99 |
| Example 19 | No | No | 97 |
| Comparative Example 1 | Yes | Yes | - |
| Comparative Example2 | No | No | 78 |
| Comparative Example3 | Yes | Yes | - |
| Comparative Example4 | Yes | Yes | - |
| Comparative Example5 | No | No | 75 |

As is clear from Table 6, in Comparative Example 1, since acetic acid was used instead of the amine-based stabilizer, the liquid composition was unstable and film roughening occurred during spin coating. In addition, during storage of the liquid composition, precipitation or gelation of the liquid occurred.

In Comparative Example 2, since sodium acetate trihydrate was used as the raw material of Na instead of sodium alkoxide, the thermal decomposition temperature of the liquid composition did not decrease and the amount of carbon residue in the film was large. Although there was no precipitation or gelation of the liquid of the liquid composition and the storage stability was good, as shown in Fig. 2, a dense piezoelectric film was not formed and the film density was low at 78%.

In Comparative Example 3, a stabilizer was not used at all, and in Comparative Example 4, an amine-based stabilizer was used, but the molar ratio was excessively small, thus, the same results as in Comparative Example 3 were obtained for each of precipitation and gelation.

In Comparative Example 5, an amine-based stabilizer was used, but the molar ratio was excessively large, thus, there was no precipitation or gelation of the liquid of the liquid composition and the storage stability was good, but the film density was low at 75%.

On the other hand, in the liquid compositions of Examples 1 to 19, since the amine-based stabilizer was included in a predetermined molar ratio, there was no precipitation or gelation of the liquid composition and the storage stability was good, and, since the raw material of Na was sodium alkoxide, the raw material of Ti was titanium alkoxide, and the amine-based stabilizer was included in a predetermined molar ratio, the film density of the obtained piezoelectric film was high at 84% to 99%. In particular, in Example 1, as shown in Fig. 1, a dense piezoelectric film was formed.

### [Industrial Applicability]

It is possible to use the liquid composition of the present invention to form a piezoelectric film for a MEMS application such as a vibration power generation element, a pyroelectric sensor, an actuator, an ink jet head, and an auto focus.

## Claims

1. A liquid composition for forming a piezoelectric film comprising:
a metal oxide including at least Bi, Na, and Ti;
wherein a raw material of the Na is a sodium alkoxide,
a raw material of the Ti is a titanium alkoxide,
a diol and an amine-based stabilizer are included, and
a molar ratio of the amine-based stabilizer to the titanium alkoxide (titanium alkoxide: amine-based stabilizer) is 1:0.5 to 1:4.

2. The liquid composition according to claim 1, further comprising:
any one selected from the group consisting of Ba, K, Mg, Zn, and Ni.

3. The liquid composition according to claim 1 or 2, further comprising:
Sr and Zr.

4. The liquid composition according to any one of claims 1 to 3,
wherein the metal oxide is included as 4% by mass to 20% by mass with respect to 100% by mass of the liquid composition.

5. A method for forming a crystallized piezoelectric film by coating a substrate with the liquid composition according to any one of claims 1 to 4 and carrying out pre-firing, and then carrying out firing.

6. A piezoelectric film formed of a metal oxide including at least Bi, Na, and Ti,
wherein a film density of the piezoelectric film is 84% to 99% when measured by a scanning electron microscope.

7. The piezoelectric film according to claim 6, further comprising:
any one selected from the group consisting of Ba, K, Mg, Zn, and Ni.

8. The piezoelectric film according to claim 6 or 7, further comprising:
Sr and Zr.

9. The piezoelectric film according to claim 6,
wherein the metal oxide is (Bi,Na)TiO₃ and has a perovskite structure.

10. The piezoelectric film according to claim 7 or 8,
wherein the metal oxide is any one selected from the group consisting of (Bi,Na)TiO₃-BaTiO₃, (Bi,Na)TiO₃-(Bi,K)TiO₃, (Bi,Na)TiO₃-Bi(Mg,Ti)O₃, (Bi,Na)TiO₃-(Bi,K)TiO₃-Bi(Zn,Ti)O₃, (Bi,Na)TiO₃-(Bi,K)TiO₃-Bi(Ni,Ti)O₃, (Bi,Na)TiO₃-SrZrO₃, and (Bi,Na)TiO₃-(Bi,K)TiO₃-SrZrO₃, and has a perovskite structure.
